# EUROPEAN PATENT APPLICATION

(11) **EP 4 270 369 A1**
(43) Date of publication of application: **01.11.2023**
(21) Application number: 21909895.1
(22) Date of filing: 08.10.2021
(51) Int. Cl.: G09F 9/00, H04N 5/64, H05K 7/00

(54) **IMAGE DISPLAY DEVICE**

(30) Priority: 25.12.2020 JP 2020217765
(71) Applicant: Panasonic Intellectual Property Management Co., Ltd., Osaka-shi, Osaka 540-6207 (JP)
(72) Inventor: FUJIKAWA, Akihiro, Kadoma-shi, Osaka 571-0057 (JP); AZUMA, Kosuke, Kadoma-shi, Osaka 571-0057 (JP)
(74) Representative: Novagraaf International SA
(86) International application number: PCT/JP2021/037461
(87) International publication number: WO 2022/137737

(57) **Abstract**

An image display device (10) includes an adapter (180), and a housing section (151) that engages with the adapter (180). The adapter (180) is attached to a cable (200) electrically connected to the image display device (10) by holding part of the cable (200) in a longitudinal direction thereof. The housing section (151) defines a housing space (154) capable of housing at least part of the adapter (180) holding the cable (200) and at least part of the part of the cable (200) that is held by the adapter (180), and engages with the adapter (180).

## Description

### [Technical Field]

The present disclosure relates to an image display device including a display panel for displaying an image.

### [Background Art]

Patent Literature (PTL) 1 discloses a thin display device in which a back face of a main body is supported by a substantially cylindrical stand. A clamper attached in an up-and-down direction with an opening facing outward, and a stopper detachably fitted to inner edges of the opening in a portion of the clamper having a substantially C-shaped cross-section are disposed on a back face of a lower part of the stand. After all cables connected to the thin display device are inserted via the opening of the clamper, the stopper is mounted to the clamper.

### [Citation List]

### [Patent Literature]

[PTL 1]
Japanese Unexamined Patent Application Publication No. 2005-196009

### [Summary of Invention]

### [Technical Problem]

The present disclosure provides an image display device in which cables can be disposed in a simple and safe way.

### [Solution to Problem]

An image display device according to the present disclosure includes: an adapter that is attached to a cable electrically connected to the image display device by holding part of the cable in a longitudinal direction of the cable; and a housing section that defines a housing space capable of housing at least part of the adapter attached to the cable and at least part of the part of the cable that is held by the adapter, and engages with the adapter.

### [Advantageous Effects of Invention]

According to the present disclosure, the image display device in which cables can be disposed in a simple and safe way can be provided.

### [Brief Description of Drawings]

[FIG. 1]

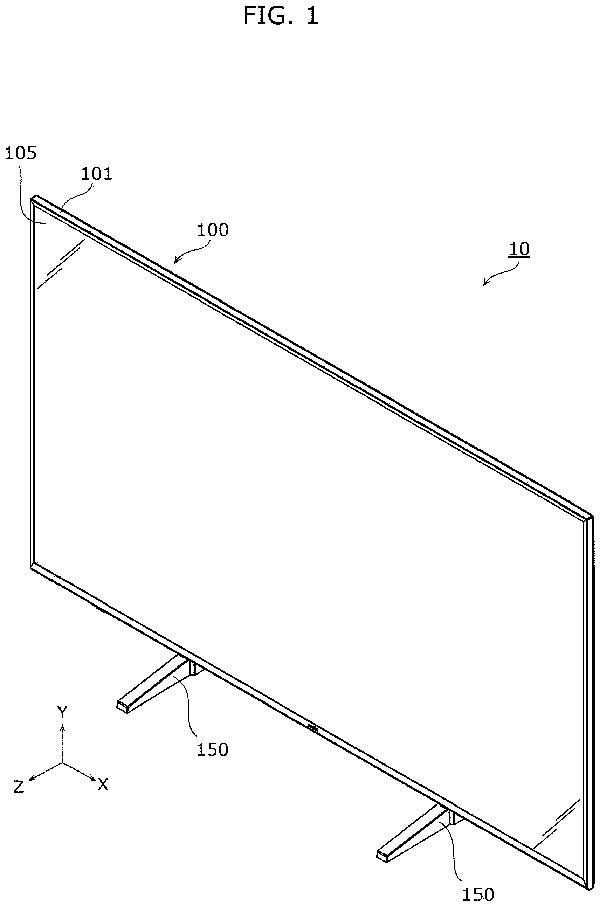

   FIG. 1 is a perspective view illustrating a front side of an image display device according to an embodiment.
[FIG. 2]

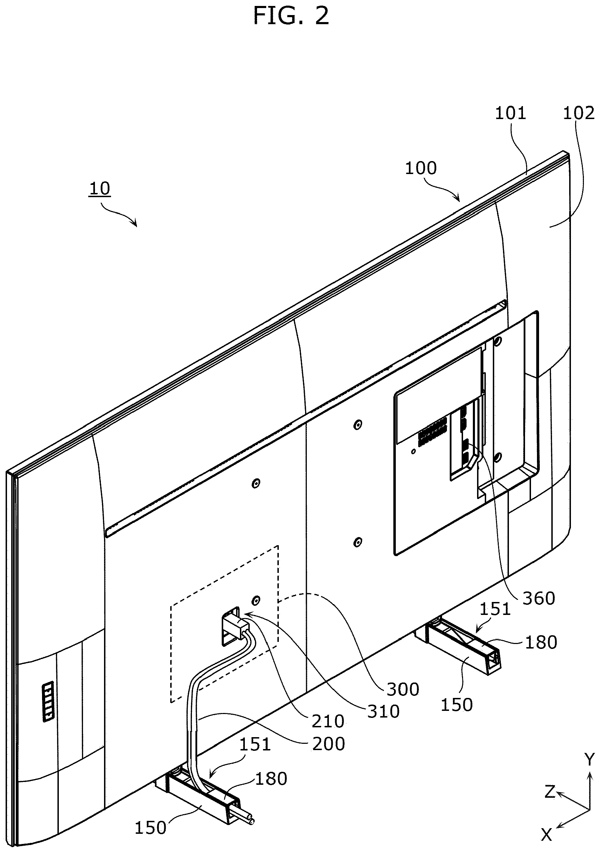

   FIG. 2 is a perspective view illustrating a back side of the image display device according to the embodiment.
[FIG. 3]

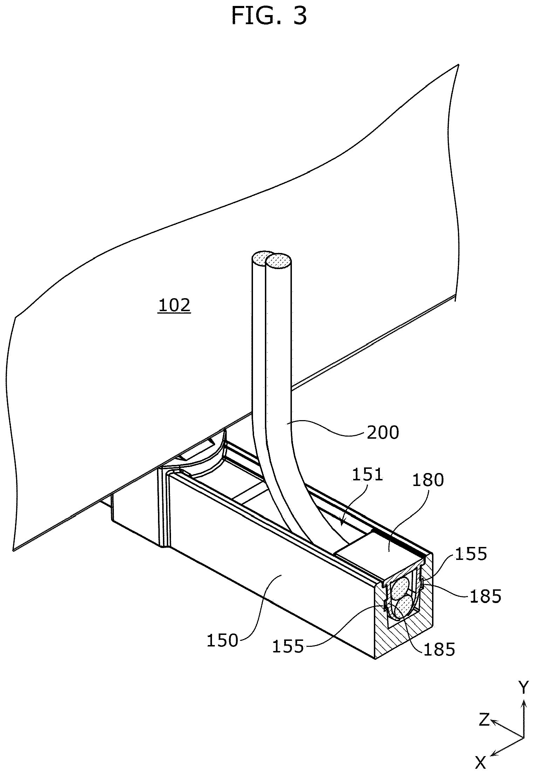

   FIG. 3 is a perspective cross-sectional view illustrating a configuration outline of a housing section and an adapter according to the embodiment.
[FIG. 4]

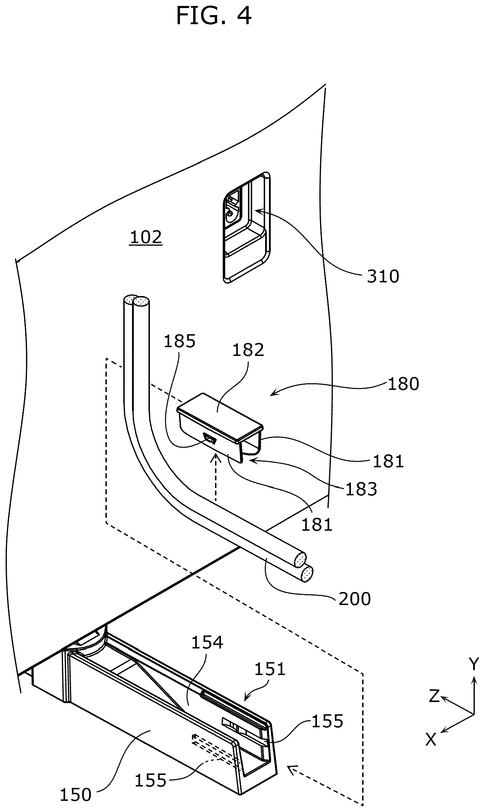

   FIG. 4 is a perspective view illustrating structural relationship between the adapter and the housing section according to the embodiment.
[FIG. 5]

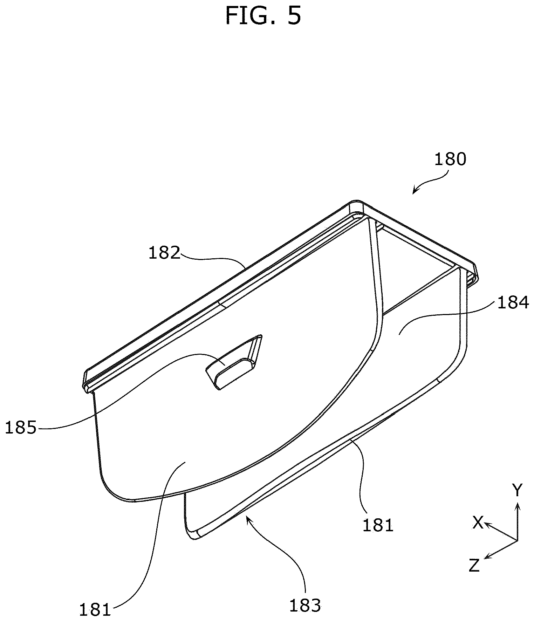

   FIG. 5 is a perspective view of the adapter according to the embodiment.
[FIG. 6]

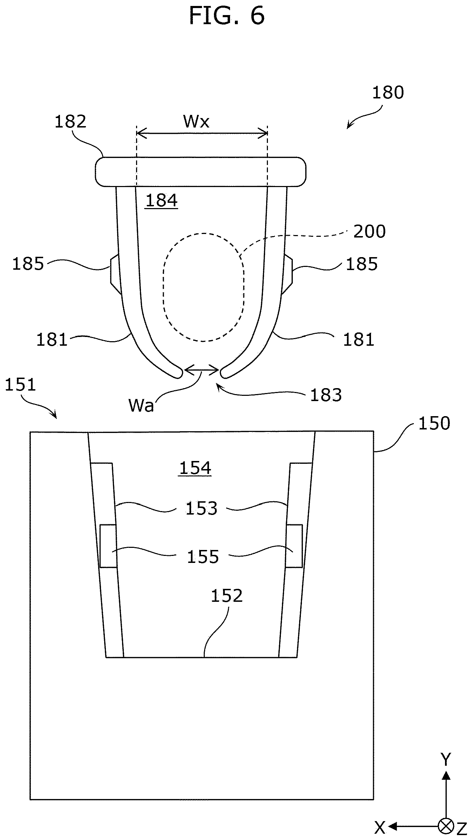

   FIG. 6 is a back view illustrating structural relationship between the adapter and the housing section according to the embodiment.
[FIG. 7]

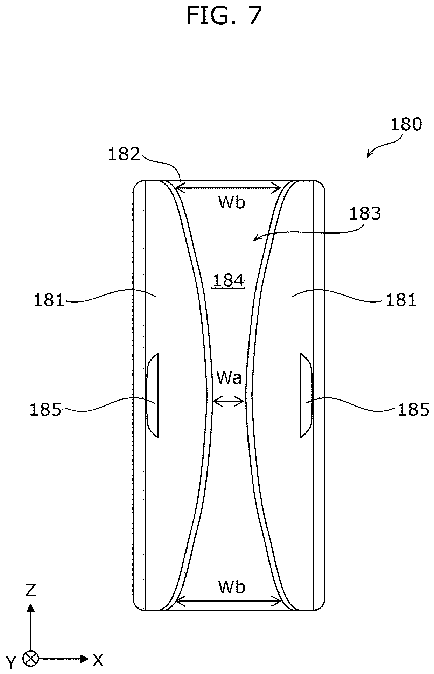

   FIG. 7 is a plan view of the adapter according to the embodiment.
[FIG. 8]

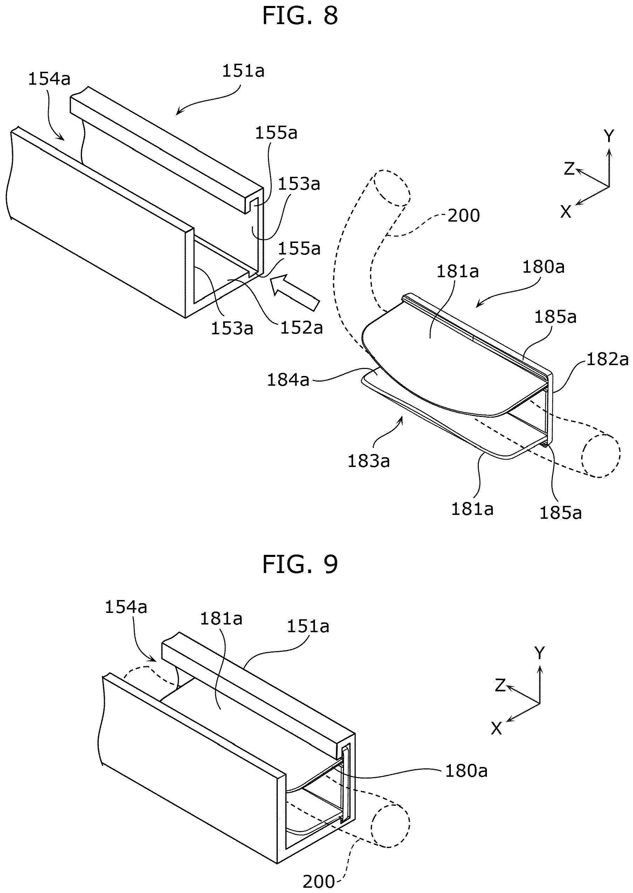

   FIG. 8 is a perspective view illustrating structural relationship between an adapter and a housing section according to Variation 1 of the embodiment.
[FIG. 9]
   FIG. 9 is a perspective view illustrating a state in which the adapter according to Variation 1 of the embodiment is housed in the housing section.
[FIG. 10]

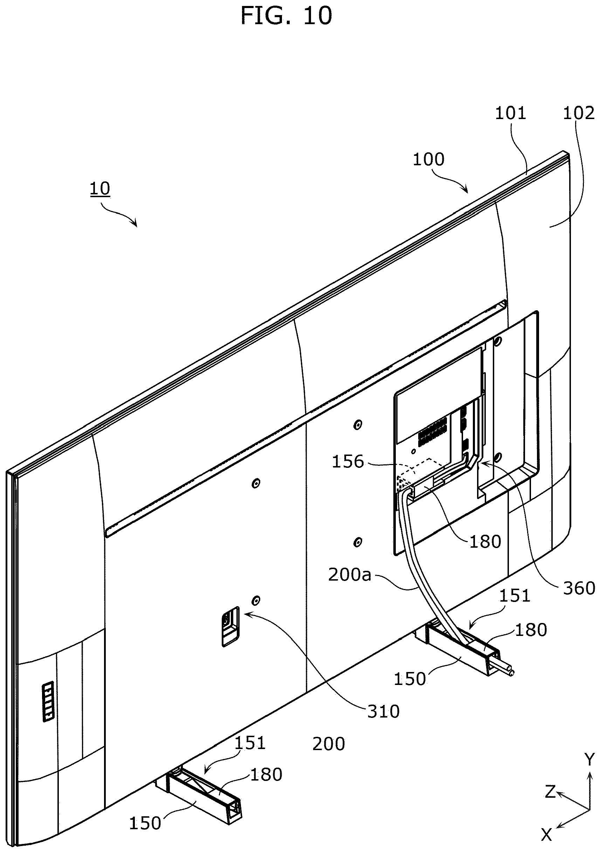

   FIG. 10 is a perspective view illustrating a back side of image display device 10 according to Variation 2 of the embodiment.
[FIG. 11A]

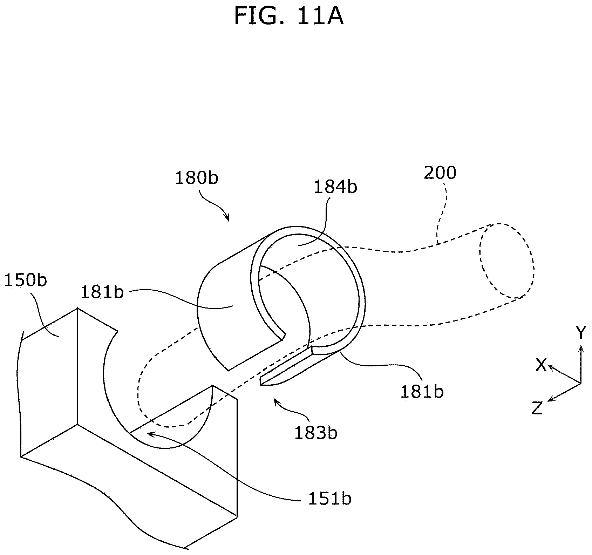

   FIG. 11A is a perspective view illustrating appearance of an adapter and a housing section according to Variation 3 of the embodiment.
[FIG. 11B]

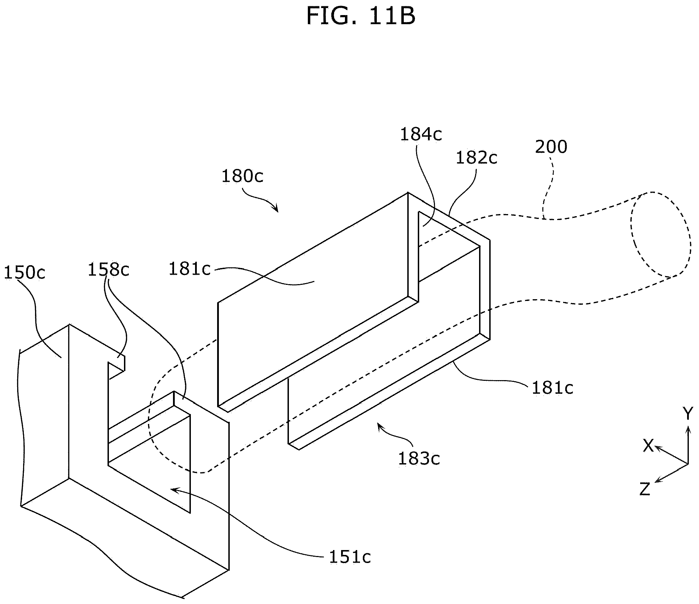

   FIG. 11B is a perspective view illustrating appearance of an adapter and a housing section according to Variation 4 of the embodiment.

### [Description of Embodiments]

The inventors of the present application have found that the following problems arise regarding conventional image display devices. Conventionally, various cables such as a power cable for receiving power supply, an audio/visual (AV) cable for inputting and outputting image data and audio data, and an antenna cable through which a signal from an antenna is transmitted are connected to an image display device such as a liquid crystal television set. Specifically, these cables are connected to connection terminals provided on a back face of a main body, including a display panel, of the image display device. In this case, since any cable hanging out of the bottom of the main body, for example, can be seen from the front, it is undesirable from the standpoint of appearance. If a cable is not restrained in any way except for the portion of the cable connected to the main body, negative effects may also arise, such as the cable interfering with an operation of connecting another cable to the main body. In this regard, the thin display device in PTL 1 described above, for example, employs a structure in which the plurality of cables are inserted through the clamper provided on the back face of the stand that supports the main body from below. Thus, the plurality of cables connected to the thin display device can be gathered in one place, and these cables can be made invisible as viewed from the front.

In the conventional thin display device described above, however, the stopper is fitted to the opening of the clamper so that no cables slip out of the opening of the clamper. Thus, if a user unintentionally pulls the cable during some operation, for example, the stopper may detach from the clamper and fly. In this case, an unsafe event may occur, such as the stopper flying at a relatively high speed hitting the user or some other object. Needless to say, it is possible to substantially prevent the detachment of the cables via the portion through which the cables are inserted, for example, by screwing the stopper. In this case, however, other problems arise, such as complicating the structure and operation for holding the cables in the image display device, and pulling a cable immediately leading to the tipping of the image display device.

The present disclosure has been made based on such finding. As a result of intensive study conducted by the inventors of the present application, an idea for the structure of an image display device in which cables can be disposed in a simple and safe way has been conceived.

Embodiments (including variations) will be described below with reference to the drawings as appropriate. Note however that description more detailed than necessary may be omitted. For example, detailed description for already well-known matters or duplicate description for substantially the same configuration may be omitted. This is to avoid the following description from becoming unnecessarily verbose and to facilitate the understanding of those skilled in the art.

In the following description of embodiments and claims, expressions describing orientations, positions, or the like of one or more objects, such as "parallel" or "center," may be used. However, these expressions also include cases not being in the orientations, positions, or the like in a strict sense. For example, "parallel" means not only being completely parallel, but also being substantially parallel, that is, including differences of about a few percent, for example. The same also applies to expressions, such as "the same" or "uniform," describing relationship between two or more pieces of information or objects.

The inventors of the present application provide the accompanying drawings and the following description so that those skilled in the art can fully understand the present disclosure. Such provision is not intended to limit the subject matter described in the claims.

In the following embodiments, for the convenience of description, an up-and-down direction coincides with a Y-axis direction, a front-and-rear direction coincides with a Z-axis direction, and a left-and-right direction (horizontal direction) coincides with an X-axis direction. However, such correspondences are not intended to limit orientation of the image display device according to the present disclosure at the time of manufacture or use thereof. In the following description, an "X-axis positive side" refers to the arrow direction side of the X-axis, and an "X-axis negative side" refers to the side opposite to the X-axis positive side, for example. The same applies also to the Y-axis direction and the Z-axis direction.

### [Embod iment]

An embodiment will be described below with reference to FIGS. 1 to 11B. First, a configuration outline of an image display device according to an embodiment will be described with reference to FIGS. 1 to 3.

### [1-1. Overall Configuration of Image Display Device]

FIG. 1 is a perspective view illustrating a front side of image display device 10 according to the embodiment. FIG. 2 is a perspective view illustrating a back side of image display device 10 according to the embodiment. FIG. 3 is a perspective cross-sectional view illustrating a configuration outline of housing section 151 and adapter 180 according to the embodiment. In FIG. 3, cable 200 is illustrated with only part of cable 200, including a part held by adapter 180, being cut out.

As shown in FIGS. 1 and 2, image display device 10 is, for example, a flat panel display type liquid crystal television set. Image display device 10 includes display unit 100, which is a main body, and a pair of stands 150 that support display unit 100. Display unit 100 includes: display panel 105 that displays an image on a front face thereof (face on the Z-axis positive side); frame member 101 that covers the periphery of the front face of display panel 105 and top, bottom, left, and right end faces of display panel 105; and back cover 102 that is connected to frame member 101 and covers display panel 105 from a back side (Z-axis negative side) thereof. Although back cover 102 is formed by a combination of a plurality of members, the group of these members is treated as back cover 102 in the present embodiment.

In the present embodiment, display panel 105 included in display unit 100 is a panel type display device capable of displaying still images and moving images, such as a liquid crystal cell or organic electro luminescence (EL) panel. Back cover 102 disposed on the back side of display unit 100 is a member that constitutes an outer shell (casing) of display unit 100 together with frame member 101. Back cover 102 is made of, for example, a resin material such as a PC (polycarbonate) or ABS (Acrylonitrile, Butadiene, Styrene) resin. Frame member 101 is, for example, a member called a bezel, which is in the shape of an annular rectangle as viewed from the front. Frame member 101 is made of a resin material such as a PC or ABS resin, or a metal such as an aluminum alloy. Frame member 101 is formed, for example, by connecting four members corresponding to four sides of rectangular display panel 105.

Back cover 102 is provided with an opening that exposes terminals of various electric circuits disposed between back cover 102 and display panel 105. That is, various terminals such as power supply terminal 310 and AV terminal 360 are disposed on the back side of image display device 10 as shown in FIG. 2, for example. Power supply terminal 310 is a terminal for receiving the supply of power to drive image display device 10. More specifically, power supply terminal 310 is a terminal for inputting power supplied from a commercial power supply to power supply circuit 300 included in image display device 10. In the present embodiment, connector 210 of cable 200, which is a power cable, is connected to power supply terminal 310 as shown in FIG. 2. AV terminal 360 is an RCA terminal, an HDMI (registered trademark) (High-Definition Multimedia Interface) terminal, or the like, and an AV cable having a connector corresponding to AV terminal 360 is connected to AV terminal 360.

In the present embodiment, cable 200 is formed by two covered electric wires as shown in FIGS. 2 and 3, but the cable to be electrically connected to image display device 10 is not limited to any particular configuration. For example, a single cable may be formed by one or three or more covered electric wires. Also, the cable to be electrically connected to image display device 10 is not limited to any particular type. For example, each of a LAN cable for connecting image display device 10 to a local area network (LAN) and an antenna cable for connecting image display device 10 and an antenna that receives radio waves is also a type of cable to be electrically connected to image display device 10.

Stand 150 is a member that supports display unit 100 from below. In the present embodiment, two stands 150 are disposed at lower end portions of display unit 100. Stand 150 is elongated in the front-and-rear direction (Z-axis direction), and includes housing section 151 in a rear (Z-axis negative side) part thereof. Housing section 151 can engage with adapter 180 and house adapter 180. Although housing section 151 and adapter 180 are disposed in each of two stands 150 in the present embodiment, housing section 151 and adapter 180 may be disposed only in one stand 150.

As shown in FIG. 3, adapter 180 is a member to be attached to cable 200 by holding cable 200. Housing section 151 houses at least part of adapter 180 attached to cable 200 and engages with adapter 180. In the present embodiment, adapter 180 becomes engaged with housing section 151 as a result of engagement protrusion 185 of adapter 180 being inserted into engagement depression 155 of housing section 151 as shown in FIG. 3. Thus, part of cable 200 in a longitudinal direction thereof is kept buried in housing section 151, which is a part of image display device 10, together with adapter 180. As a result, cable 200 is hidden from a user positioned in front of image display device 10. Adapter 180 and housing section 151 to be mechanically engaged with each other in this manner will be further described in detail with reference to FIGS. 4 to 7.

### [1-2. Details of Configurations of Adapter and Housing Section]

FIG. 4 is a perspective view illustrating structural relationship between adapter 180 and housing section 151 according to the embodiment. In FIG. 4, part of the back side of image display device 10 is shown as a perspective view, and cable 200 is illustrated with only part thereof being cut out. FIG. 5 is a perspective view of adapter 180 according to the embodiment. FIG. 6 is a back view illustrating structural relationship between adapter 180 and housing section 151 according to the embodiment. In FIG. 6, shapes of adapter 180 and housing section 151 as viewed from the back side (Z-axis negative side) thereof are illustrated in a simplified manner. As to cable 200, an approximate size of its cross-section perpendicular to the longitudinal direction of cable 200 is indicated by a dotted oval. FIG. 7 is a plan view of adapter 180 according to the embodiment. FIG. 7 illustrates adapter 180 as viewed from a leading end side (opening 183 side) of holding wall portion 181.

Adapter 180 is a member made of, for example, a resin such as a PP (polypropylene), nylon, PC, or ABS resin. In the present embodiment, adapter 180 has a structure in which a pair of holding wall portions 181 disposed facing each other are coupled by coupling wall portion 182 as shown in FIGS. 4 to 7. Holding space 184, which is a space where cable 200 is disposed, is formed between the pair of holding wall portions 181. Part of cable 200 in the longitudinal direction thereof can be inserted into holding space 184 via opening 183. Adapter 180 thus achieves a state of holding cable 200. That is, adapter 180 is attached to cable 200. In the present embodiment, housing section 151 is a groove portion provided recessed from a top face of stand 150, and has housing space 154 that opens upward (Y-axis positive side) and rearward (Z-axis negative side). Housing space 154 is provided with a size capable of housing at least part of the part of cable 200 that is held by adapter 180 together with at least part of adapter 180. In the present embodiment, the part of cable 200 that is held by adapter 180 is entirely housed in housing space 154 together with entire adapter 180. As shown in FIG. 6, for example, housing section 151 includes bottom face portion 152 that is a bottom face of housing space 154, and lateral face portions 153 that are a pair of lateral faces adjacent to the bottom face. Lateral face portion 153 is provided with engagement depression 155 extending in the front-and-rear direction (Z-axis direction). Engagement protrusion 185 of adapter 180 to be housed in housing section 151 is inserted into engagement depression 155. Adapter 180 thus becomes engaged with housing section 151.

As just described, image display device 10 according to the present embodiment includes adapter 180, and housing section 151 that engages with adapter 180. Adapter 180 is attached to cable 200 by holding part of cable 200, in the longitudinal direction thereof, electrically connected to image display device 10. Housing section 151 forms housing space 154 capable of housing at least part of adapter 180 holding cable 200 and at least part of the part of cable 200 that is held by adapter 180, and engages with adapter 180. That is, housing section 151 does not simply house part of cable 200, but can house part of cable 200 together with adapter 180 attached to cable 200 and can engage with adapter 180. Ways to hold cable 200 by adapter 180 include a way in which cable 200 is prevented from slipping out of opening 183 (see FIG. 6) by setting a width of the opening to be smaller than an outer diameter of cable 200, a way in which cable 200 is clamped in a radial direction thereof by the pair of holding wall portions 181, and a combination of these ways, for example. That is, while adapter 180 is holding cable 200, adapter 180 is not easily disengaged from cable 200 due to the structural engagement of these two members, friction force between these two members, or the like.

According to this configuration, part of cable 200 in the longitudinal direction thereof can be locked into housing section 151 by adapter 180. That is, adapter 180 can retain the part of cable 200 within housing space 154 of housing section 151. It is therefore possible to hide the part of cable 200 from the user. The orientation of cable 200 can be adjusted by housing the part of cable 200 in housing section 151. As a result, it is also possible to make most of cable 200 invisible when image display device 10 is viewed from the front side, for example. In the present embodiment, in particular, because housing section 151 is provided in a portion of stand 150 that projects toward the back side from display unit 100, it is also possible to hide almost entire cable 200 from the user positioned on the front side of display unit 100. If cable 200 is pulled in this state, adapter 180 attached to housing section 151 by engaging with housing section 151 may be detached from housing section 151 together with cable 200 at the time of the disengagement of cable 200 from housing section 151. However, adapter 180 still holds the part of cable 200 even when adapter 180 is detached from housing section 151, and the possibility for adapter 180 to fly due to inertial force is therefore low. That is, adapter 180 is more likely to be kept attached to cable 200. Thus, an unsafe event, such as adapter 180 flying at a relatively high speed hitting the user or some other object, for example, is less likely to occur.

Because adapter 180 is retained in housing section 151 using a simple technique of engagement rather than a solid technique such as fastening or bonding, adapter 180 can be detached from housing section 151 by losing to the force of pulling cable 200 as described above. Thus, pulling cable 200 does not immediately lead to the tipping of image display device 10, and safety is improved in this regard as well. Specifically, when cable 200 is pulled with a relatively strong force, adapter 180 becomes disengaged from housing section 151 by losing to the force of cable 200 acting to cause disengagement from housing section 151. First, at this point, it can be expected that the user who accidentally pulls cable 200 recognizes the disengagement of adapter 180 from housing section 151 (or some abnormal event) visually, aurally, or tactually, for example, and thus stops the action of pulling cable 200. If pulling cable 200 leads to the disengagement of adapter 180 from housing section 151, cable 200 becomes loose once. At this point, the tension applied by cable 200 to image display device 10 becomes almost zero. Thus, if the state in which cable 200 is being pulled ends during the period when cable 200 is loose, image display device 10 is prevented from tipping. For this reason, it can be said that pulling cable 200 does not immediately lead to the tipping of image display device 10. Furthermore, because adapter 180 is attached to housing section 151 without using another member such as a screw or an adhesive, cable 200 can be disposed with respect to image display device 10 with the simple configuration.

By using adapter 180 to lock cable 200 into housing section 151, various cables 200 can be locked into housing section 151 using adapter 180 as long as the outer diameter of cable 200 is within a range in which cable 200 can be held by adapter 180, for example. That is, when various cables 200 are locked into housing section 151, differences in outer diameters of cables 200 can be compensated for by adapter 180.

Furthermore, at least part of the part of cable 200 that is held by adapter 180 is housed in housing space 154 of housing section 151 together with at least part of adapter 180. Thus, the amount of space around image display device 10 occupied by cable 200 and adapter 180 is reduced, and the effective utilization of such surrounding space can be thereby achieved.

As described above, image display device 10 according to the present embodiment enables cable 200 to be disposed in a simple and safe way.

In the present embodiment, the part of cable 200 that is held by adapter 180 is entirely housed in housing space 154 of housing section 151 together with entire adapter 180 as shown in FIGS. 3 and 4. Thus, an outer surface of adapter 180 can be made flush with an outer surface around housing section 151. As a result, effects such as improving design and preventing accidental removal of adapter 180, for example, can be obtained. However, the part of cable 200 that is held by adapter 180 and adapter 180 may each partly project from housing space 154. That is, it is sufficient that at least part of each of the part of cable 200 that is held by adapter 180 and adapter 180 is housed in housing space 154. This allows adapter 180 to be engaged with housing section 151, and the amount of space around image display device 10 occupied by cable 200 and adapter 180 is thus reduced.

More specifically, adapter 180 according to the present embodiment has the pair of holding wall portions 181 disposed facing each other in a first direction (the X-axis direction in the present embodiment) as shown in FIGS. 4 to 7. Holding space 184 (see FIGS. 5 to 7) for holding cable 200 is formed between the pair of holding wall portions 181. Holding space 184 has an end that is closed in a second direction (the Y-axis direction in the present embodiment) perpendicular to the X-axis direction, and the other end that is open in the Y-axis direction. As shown in FIG. 6, minimum distance Wa between the leading ends of the pair of holding wall portions 181 on the open side (Y-axis negative side) of holding space 184 is smaller than maximum distance Wx between the pair of holding wall portions 181 in the X-axis direction.

In the present embodiment, ends of the pair of holding wall portions 181 on the Y-axis positive side are coupled by coupling wall portion 182 that is in the shape of a flat plate. As shown in FIG. 6, when adapter 180 is viewed from an insertion direction (the Z-axis direction) of cable 200, holding space 184 is a space surrounded by the pair of holding wall portions 181 and coupling wall portion 182. That is, holding space 184 is a space in which the end thereof on the Y-axis positive side is closed and the end thereof on the Y-axis negative side is open in the Y-axis direction. In the present embodiment, maximum distance Wx between the pair of holding wall portions 181 in the X-axis direction is a distance between root portions (portions connected with coupling wall portion 182) of the pair of holding wall portions 181.

According to this configuration, cable 200 can be inserted into holding space 184 through opening 183 formed by a gap between the leading ends of the pair of holding wall portions 181. Since the width of opening 183 (width in the X-axis direction, the same applies hereinafter) is narrowed, cable 200 in the held state is less likely to come out of adapter 180.

For example, maximum distance Wx between holding wall portions 181 is set to a value equal to or greater than the maximum outer diameter of cable 200 to be held by (to be fitted with) adapter 180. Furthermore, minimum distance Wa (the width of opening 183) between the leading ends of the pair of holding wall portions 181 is set to be smaller than the minimum outer diameter of cable 200 to be held by (to be fitted with) adapter 180. As shown in FIG. 6, when the cross-sectional shape of cable 200 has a minor axis and a major axis, minimum distance Wa (the width of opening 183) is set to be smaller than the minor axis. Thus, adapter 180 can be attached to various cables 200 having outer diameters different from one another, and adapter 180 is less likely to detach easily from cable 200 once attached thereto. That is, adapter 180 has a structure with which adapter 180 may move along the longitudinal direction of cable 200, but adapter 180 is less likely to detach from cable 200 in the radial direction (direction perpendicular to the longitudinal direction) of cable 200. That is, unlike a case where the holding state of cable 200 is maintained only by friction force between the pair of holding wall portions 181 and cable 200, for example, the state of holding cable 200 is maintained by mechanical engagement (hooking). Thus, even when cable 200 is pulled and adapter 180 is thereby detached from housing section 151, the possibility that adapter 180 becomes detached from cable 200 and flies is further reduced.

In opening 183, which is a slot for inserting cable 200 in adapter 180, width Wb at ends of opening 183 in an extending direction (longitudinal direction) thereof is larger than minimum distance Wa between the leading ends of the pair of holding wall portions 181 as shown in FIG. 7. More specifically, opening 183 is provided in such a manner that the both ends of opening 183 in the longitudinal direction thereof are wide and opening 183 becomes gradually narrower toward its center. Thus, cable 200 can be easily inserted into opening 183 from the longitudinal direction of opening 183, and once cable 200 is inserted into holding space 184 of adapter 180, cable 200 becomes less likely to exit from opening 183. Although adapter 180 is not limited to any particular overall size, adapter 180 is formed so as to have a size that prevents accidental swallowing by children, for example, considering that adapter 180 is detachable from housing section 151 and cable 200.

In adapter 180, the leading end of at least one of the pair of holding wall portions 181 is in a shape that is bent toward the other of the pair of holding wall portions 181. By forming the leading end of holding wall portion 181 into a shape bent inward in this manner, adapter 180 can be made less likely to detach from cable 200. That is, there is obtained adapter 180 that can be attached to cable 200 afterward with a simple shape, and becomes less likely to detach from cable 200 once attached thereto. For example, when adapter 180 is removed from housing section 151, cable 200 is more likely to be hooked by the leading end of holding wall portion 181 which is in a shape that is bent inwardly. Thus, cable 200 can be easily taken out of housing section 151 together with adapter 180. Furthermore, it is also possible to form opening 183 having a narrow width by tilting inward entire holding wall portions 181 each in the shape of a flat plate extending up to the leading end thereof, for example. In this case, however, holding space 184 is substantially triangular as viewed from the insertion direction of cable 200. As a result, holding space 184 becomes relatively small. In this regard, according to the present embodiment, opening 183 having a narrow width is obtained by bending the leading end of holding wall portion 181 inward. Thus, relatively large holding space 184 can be obtained. This allows adapter 180 to be attached to thicker cable 200 or a larger number of cables 200.

More specifically, in the present embodiment, the leading end of each of the pair of holding wall portions 181 is in a shape that is bent toward (inward) the other holding wall portion 181. Adapter 180 is therefore symmetrical in shape, in a planar view, both in a longitudinal direction (the Z-axis direction) and a transverse direction (the X-axis direction) thereof as shown in FIG. 7, for example. Thus, when housing adapter 180 in (attaching adapter 180 to) housing section 151, for example, the user handling adapter 180 can conduct the attachment operation without concern for the direction of adapter 180 in a planar view. Since the part of holding wall portion 181 excluding its leading end may be in the shape of a flat plate, the pair of holding wall portions 181 in those parts excluding the leading ends can be disposed substantially parallel to each other, for example. Thus, friction force between each of the pair of holding wall portions 181 and lateral face portion 153 (see FIG. 6) facing such holding wall portion 181, for example, can be efficiently utilized as a force for fixing adapter 180 in housing section 151.

In the present embodiment, housing section 151 is shaped to house at least part of adapter 180 with an orientation in which the leading ends of the pair of holding wall portions 181 in adapter 180 face bottom face portion 152 that is the bottom face of housing space 154. That is, adapter 180 is housed in housing section 151 with opening 183 facing the bottom face of housing space 154.

According to this configuration, if cable 200 held by adapter 180 moves so as to be detached from housing section 151, the closed end of holding space 184 in adapter 180 is located in that direction. Specifically, in the present embodiment, coupling wall portion 182 of adapter 180 serves as a lid for preventing the detachment of cable 200 from housing section 151. Thus, cable 200 can be prevented from detaching from housing section 151 by itself while leaving behind adapter 180 engaged with housing section 151, for example. From the standpoint of appearance, adapter 180 also serves as a member for hiding the part of cable 200 housed in housing section 151. Furthermore, in removing adapter 180, together with cable 200, from housing section 151, the pair of holding wall portions 181 are restrained from opening outward by housing section 151 until adapter 180 is withdrawn from housing section 151. Thus, cable 200 is less likely to detach from adapter 180. That is, the operation of removing adapter 180 from housing section 151 together with cable 200 can be easily conducted. This effect becomes prominent when the pair of holding wall portions 181 have engagement protrusions 185 that protrude outward as in the present embodiment.

One of adapter 180 or housing section 151 has an engagement protrusion, and the other of adapter 180 or housing section 151 has an engagement depression. In the present embodiment, adapter 180 has engagement protrusion 185, and housing section 151 has engagement depression 155 as shown in FIGS. 3 to 7. Adapter 180 becomes engaged with housing section 151 as a result of engagement protrusion 185 being inserted into engagement depression 155.

That is, there is obtained an engagement structure that allows adapter 180 and housing section 151 to be engaged with each other with a simple configuration of inserting a protrusion into a depression, and can achieve a substantially unproblematic level of coupling strength in use. For example, the difficulty of releasing the coupled state between engagement protrusion 185 and engagement depression 155 is changed by altering the size or shape of engagement protrusion 185 and the size or shape of engagement depression 155. That is, the coupling strength between adapter 180 and housing section 151 can be easily adjusted.

In the present embodiment, housing section 151 is a groove portion elongated in the front-and-rear direction, which is provided in a part of image display device 10 (see FIG. 4). One of engagement protrusion 185 or engagement depression 155 is provided, along a longitudinal direction of the groove portion, from an end of the groove portion in the longitudinal direction. Specifically, housing section 151 is provided in stand 150, which is a part of image display device 10, as a groove portion elongated in the front-and-rear direction. In each of the pair of lateral face portions 153 (see FIG. 6) of housing section 151, an elongated groove is provided as engagement depression 155 from a rear end of lateral face portion 153 toward the front. Adapter 180 is provided with engagement protrusion 185 on an outer surface of each of the pair of holding wall portions 181. Adapter 180 attached to cable 200 is housed in housing section 151 by being moved so as to slide forward from the rear end opening of housing section 151 as shown in FIG. 4, for example. At this time, the pair of engagement protrusions 185 are inserted up to front ends of engagement depressions 155 while sliding with engagement depressions 155 that are elongated in the front-and-rear direction. Adapter 180 thus becomes engaged with housing section 151. That is, engagement depression 155 is formed into a shape that facilitates the insertion of engagement protrusion 185 when adapter 180 is housed in housing section 151, and makes it difficult for engagement protrusion 185 to detach upward from engagement depression 155 when cable 200 is pulled. For example, in part of engagement depression 155, which is formed in a groove shape, in the longitudinal direction thereof, a projection for reducing the depth of the groove is disposed. Thus, in housing adapter 180 in housing section 151, engagement protrusion 185 crosses over the projection when engagement protrusion 185 moves forward from a rear end of engagement depression 155. As a result, adapter 180 becomes less likely to fall off from the rear end side of housing section 151.

The direction in which adapter 180 is housed (inserted) into housing section 151 needs not necessarily be in the front-and-rear direction. For example, assume that each of the pair of holding wall portions 181 is deformable so as to approach each other with adapter 180 being held by the user, such as a case where the thickness of one or more cables 200 held by adapter 180 is relatively small. In this case, adapter 180 can be housed into housing space 154 through the upper opening of housing space 154 in housing section 151 with the pair of holding wall portions 181 of adapter 180 being pinched with fingers so as to approach each other. The fact that adapter 180 can be housed in housing section 151 from the upper part of housing section 151 through the use of the elastic deformation thereof means that the reverse is also possible (adapter 180 is detached upward from housing section 151 through the use of the elastic deformation thereof). Adapter 180 according to the present embodiment, however, is disposed while holding cable 200, unlike a stopper or lid that simply blocks part of the opening of housing section 151. Thus, adapter 180 is retained somewhere on cable 200 in the longitudinal direction thereof even when cable 200 is pulled and adapter 180 is thereby detached from housing section 151 as described above.

Adapter 180 and housing section 151 included in image display device 10 according to the embodiment have been described above in terms of the structural relationship therebetween, and the like. However, structural relationship between adapter 180 and housing section 151 and configurations of adapter 180 and housing section 151 may be different from the structural relationship or configurations shown in FIGS. 2 to 7. Variations of adapter 180 and housing section 151 will be described focusing on differences from the embodiment described above.

### [2-1. Variation 1]

FIG. 8 is a perspective view illustrating structural relationship between adapter 180a and housing section 151a according to Variation 1 of the embodiment. FIG. 9 is a perspective view illustrating a state in which adapter 180a according to Variation 1 of the embodiment is housed in housing section 151a. In FIGS. 8 and 9, only part of cable 200, including a part held by adapter 180a, is cut out, and the outline thereof is illustrated by a dotted line.

Adapter 180a and housing section 151a according to the present variation have common configurations with adapter 180 and housing section 151 according to the embodiment. That is, adapter 180a has a pair of holding wall portions 181a disposed facing each other, and coupling wall portion 182a that couples the pair of holding wall portions 181a. A gap between leading ends of the pair of holding wall portions 181a is utilized as opening 183a for inserting and withdrawing cable 200 into and from holding space 184a of adapter 180a. Housing section 151a is provided, for example, in stand 150 (see FIGS. 1 and 2) as an elongated groove portion. Housing space 154a that houses adapter 180a is defined by bottom face portion 152a and a pair of lateral face portions 153a.

In the present variation, housing section 151a is shaped to house at least part of adapter 180a with an orientation in which the leading ends of the pair of holding wall portions 181a in adapter 180a face lateral face portion 153a that is a lateral face adjacent to a bottom face of housing space 154a. That is, the present variation is characterized in that adapter 180a is housed in housing section 151a with an orientation in which opening 183a faces the lateral face of housing space 154a.

According to this configuration, one of the pair of holding wall portions 181a of adapter 180a serves as a lid for preventing the detachment of cable 200 from housing section 151a. Thus, cable 200 can be prevented from detaching from housing section 151a by itself while leaving behind adapter 180a engaged with housing section 151a, for example. From the standpoint of appearance, adapter 180a also serves as a member for hiding the part of cable 200 housed in housing section 151a.

In the present variation, in adapter 180a, both ends of coupling wall portion 182a in a direction in which the pair of holding wall portions 181a face each other (the Y-axis direction) serve as engagement protrusions 185a. Housing section 151a is provided with engagement depression 155a into which engagement protrusion 185a is inserted at each of an upper end and a lower end of lateral face portion 153a that faces coupling wall portion 182a. Adapter 180a thus configured is housed in housing section 151a by being moved so as to slide forward from a rear end opening of housing section 151a. At this time, the pair of engagement protrusions 185a are inserted up to front ends of engagement depressions 155a while sliding with engagement depressions 155a that are elongated in the front-and-rear direction. Adapter 180a thus becomes engaged with housing section 151a. As just described, adapter 180a can be engaged with housing section 151a even when adapter 180a takes on the orientation in which opening 183a faces lateral face portion 153a. The engagement structure between adapter 180a and housing section 151a shown in FIGS. 8 and 9 is provided by way of example. For example, adapter 180a may be engaged with housing section 151a as a result of the leading end of holding wall portion 181a of adapter 180a being inserted into a groove provided on lateral face portion 153a that faces such a leading end. That is, the leading end of holding wall portion 181a may serve as an engagement protrusion, and the groove provided on lateral face portion 153a may serve as an engagement depression. In this case, since the leading end of upper (the Y-axis positive side) one of the pair of holding wall portions 181a serves as an engagement protrusion, the pair of holding wall portions 181a become less likely to deform so as to open. This makes it difficult for cable 200 to exit upward from housing section 151a.

### [2-2. Variation 2]

FIG. 10 is a perspective view illustrating a back side of image display device 10 according to Variation 2 of the embodiment. FIG. 10 illustrates a structure in which cable 200a, which is an AV cable, is held by adapter 180. Image display device 10 according to the present variation is characterized in that housing section 156 is provided in a back face of display unit 100, which is a main body of image display device 10.

That is, in the present variation, housing section 156 that houses at least part of part of cable 200a that is held by adapter 180 together with at least part of adapter 180 is provided in back cover 102 that is the back face of display unit 100. More specifically, housing section 156 is buried in a back face of back cover 102. Even in this case, housing section 156 can engage with adapter 180 holding cable 200a, for example, by having a common configuration with housing section 151 according to the embodiment. Thus, cable 200a can be disposed with respect to image display device 10 in a simple and safe way.

Housing section 156 may be molded integrally with back cover 102, or may be fixed to back cover 102 as a separate part. Housing section 156 needs not necessarily be buried in the back face of back cover 102. For example, housing section 156 may be disposed with at least part of adapter 180 projecting from the back face of back cover 102. Although FIG. 10 illustrates housing section 151 provided in stand 150 and housing section 156 provided in back cover 102, housing section 151 provided in stand 150 may be omitted if housing section 156 is present.

As just described, there is no particular limitation on the position where the housing section that houses adapter 180 and engages with adapter 180 is disposed in image display device 10. Note however that the housing section is advantageously provided on the back side of image display device 10 when adapter 180 is attached to cable 200a connected to the back side of image display device 10 as shown in FIGS. 2 and 10. Specifically, providing the housing section on the back side of image display device 10 is advantageous, for example, in that cable 200 can be hidden from a user positioned on the front side of image display device 10.

Adapter 180 holding part of cable 200 (see FIG. 2), which is a power cable, in a longitudinal direction thereof may be housed in housing section 156, shown in FIG. 10, disposed in the back face of display unit 100. In this case, housing section 156 may be provided at a position suitable for the position where cable 200 is disposed, such as a position close to power supply terminal 310, for example.

### [2-3. Variation 3]

FIG. 11A is a perspective view illustrating appearance of adapter 180b and housing section 151b according to Variation 3 of the embodiment. Adapter 180b according to the present variation is a simple annular member in which a portion thereof is cut off. That is, in adapter 180b, a pair of holding wall portions 181b are connected together without having a clear boundary. Furthermore, unlike adapter 180 according to the embodiment, adapter 180b according to the present variation is shaped in such a manner that a length of adapter 180b in an insertion direction (the Z-axis direction) of cable 200 is smaller than an outer diameter of adapter 180b.

Even with thus shaped adapter 180b, the cut-off portion serves as opening 183b for inserting and withdrawing cable 200 into and from holding space 184b inside adapter 180b. By widening (elastically deforming) opening 183b, cable 200 can be inserted into holding space 184b of adapter 180b from a radial direction of cable 200. That is, cable 200 can be held by adapter 180b. Furthermore, because a width (natural length) of opening 183b is smaller than a thickness of cable 200, cable 200 disposed in holding space 184b is prevented from exiting out from opening 183b unless opening 183b is further opened.

Adapter 180b thus configured is housed in housing section 151b shown in FIG. 11A, for example. Housing section 151b is provided, for example, in a rear end portion of stand 150b (end on the Z-axis negative side). Housing section 151b engages with adapter 180b in the Y-axis direction because a width of an opening of housing section 151b positioned on the Y-axis positive side is smaller than the outer diameter of adapter 180b. That is, an outer peripheral surface of adapter 180b serves as an engagement protrusion, and an inner peripheral surface of housing section 151b serves as an engagement depression. This allows adapter 180b holding part of cable 200 in a longitudinal direction thereof to be housed in housing section 151b and engaged with housing section 151b. Even when cable 200 is pulled and adapter 180b thus engaged with housing section 151b thereby exits upward (the Y-axis positive side) from housing section 151b, for example, adapter 180b is retained on cable 200. Thus, according to image display device 10 including housing section 151b and adapter 180b according to the present variation, cable 200 electrically connected to image display device 10 can be disposed in a simple and safe way. For example, a projection may be disposed on a surface of housing section 151b to abut on adapter 180b in order to prevent the exit (fall) of adapter 180b from a rear end (end on the Z-axis negative side) of housing section 151b.

### [2-4. Variation 4]

FIG. 11B is a perspective view illustrating appearance of adapter 180c and housing section 151c according to Variation 4 of the embodiment. Adapter 180c according to the present variation includes a pair of holding wall portions 181c disposed facing each other, and coupling wall portion 182c, which is in the shape of a flat plate, for coupling the pair of holding wall portions 181c. Holding space 184c is defined by these three wall portions, and opening 183c is provided at a position facing coupling wall portion 182c. As to this configuration, adapter 180c according to the present variation is in common with adapter 180 according to the embodiment.

However, the pair of holding wall portions 181c according to the present variation are both in the shape of a flat plate and are disposed with an orientation parallel to each other. That is, holding wall portion 181c according to the present variation is characterized in that holding wall portion 181c has no inwardly bent leading end (see FIG. 6) as in holding wall portion 181 of adapter 180 according to the embodiment. More specifically, the pair of holding wall portions 181c that are in the shape of a flat plate and disposed parallel to each other are disposed close enough to clamp cable 200 in a radial direction thereof. That is, adapter 180c according to the present variation can hold cable 200 by clamping cable 200 in the radial direction thereof by the pair of holding wall portions 181c. In other words, adapter 180c can hold cable 200 (be attached to cable 200) due to friction force between the pair of holding wall portions 181c and cable 200. Adapter 180c attached to cable 200 is prevented from detaching from cable 200 unless a user applies force thereto so as to separate adapter 180c from cable 200, for example.

Adapter 180c thus configured is housed in housing section 151c shown in FIG. 11B, for example. Housing section 151c is provided, for example, in a rear end portion of stand 150c (end on the Z-axis negative side), and has a pair of engagement protrusions 158c facing each other at an end of housing section 151c on the Y-axis positive side. Housing section 151c engages with adapter 180c housed in housing section 151c in the Y-axis direction because a distance between the pair of engagement protrusions 158c is smaller than a width of adapter 180c in the X-axis direction. This allows adapter 180c holding part of cable 200 in a longitudinal direction thereof to be housed in housing section 151c and engaged with housing section 151c. Even when cable 200 is pulled and adapter 180c thus engaged with housing section 151c thereby exits upward (the Y-axis positive side) from housing section 151c, for example, adapter 180c is retained on cable 200. Thus, according to image display device 10 including housing section 151c and adapter 180c of the present variation, cable 200 electrically connected to image display device 10 can be disposed in a simple and safe way. For example, a projection may be disposed on a surface of housing section 151c to abut on adapter 180c in order to prevent the exit (fall) of adapter 180c from a rear end (end on the Z-axis negative side) of housing section 151c.

### [Other Embodiments]

As described above, the embodiment and the variations thereof have been described as examples of the technology disclosed in the present application. However, the technology in the present disclosure is not limited thereto, and can be applied also to embodiments and variations in which modifications, replacements, additions, omissions, and the like are made as appropriate. It is also possible to combine the components described in the above embodiment and variations to make a new embodiment. In view of this, other embodiments will be provided below as examples.

For example, adapter 180 may have an engagement depression, and housing section 151 may have an engagement protrusion. Furthermore, one of a pair of holding wall portions 181 of adapter 180 may have an engagement protrusion, and the other of the pair of holding wall portions 181 may have an engagement depression. In this case, in housing section 151, an engagement depression may be provided at a position facing the engagement protrusion of adapter 180, and an engagement protrusion may be provided at a position facing the engagement depression of adapter 180. That is, when adapter 180 and housing section 151 are engaged with each other as a result of the engagement protrusion being inserted into the engagement depression, positions and the number of each of the engagement protrusion and the engagement depression may be appropriately determined according to shapes, sizes, or the like of adapter 180 and housing section 151. Furthermore, the engagement depression and the engagement protrusion are not limited to any particular shapes. Since the engagement depression and the engagement protrusion may be in any shapes capable of being engaged with each other, various shapes can be employed.

For example, adapter 180 may be attached to a plurality of cables 200, differing from one another in type or size, so as to bundle the plurality of cables 200. For example, adapter 180 may be attached to two or more cables 200, including a power cable and an AV cable, by holding these two or more cables 200 together. This allows part of each of the plurality of cables 200 having connection positions (positions of connection terminals) different from one another in image display device 10 to be housed together in one place (housing section 151), for example.

There is no particular limitation on material for forming adapter 180. As mentioned above, a resin such as a PP, nylon, PC, or ABS resin is employed as a material for forming adapter 180 in consideration of high deformation ability and high resilience, ease of forming various shapes, or weight reduction, for example. In consideration of durability, or heat resistance, for example, aluminum, copper, or iron, or an alloy containing these metals is employed as a material for forming adapter 180.

The supplementary matters described above regarding adapter 180 or housing section 151 according to the embodiment may be applied to any of adapters 180, and 180a to 180c, and housing sections 151a to 151c, and 156 according to any of Variations 1 to 4.

As described above, the embodiments have been described to illustrate the technology according to the present disclosure. The accompanying drawings and the detailed description are provided for this purpose. Thus, components shown in the accompanying drawings and described in the detailed description may include not only components that are essential for solving problems, but also components that are not essential for solving problems in order to illustrate the technology described above. Therefore, such inessential components should not be readily construed as being essential based on the fact that such inessential components are shown in the accompanying drawings or described in the detailed description.

The embodiments described above are provided to illustrate the technology according to the present disclosure, and therefore various modifications, replacements, additions, omissions, and the like may be made within the scope of the claims or the scope of the equivalents thereof.

### [Industrial Applicability]

The present disclosure can be applied to image display devices for displaying images. Specifically, the present disclosure can be applied to television sets, monitor displays, digital signage, and the like.

### [Reference Signs List]

10 Image display device
100 Display unit
101 Frame member
102 Back cover
105 Display panel
150, 150b, 150c Stand
151, 151a, 151b, 151c, 156 Housing section
152, 152a Bottom face portion
153, 153a Lateral face portion
154, 154a Housing space
155, 155a Engagement depression
158c, 185, 185a Engagement protrusion
180, 180a, 180b, 180c Adapter
181, 181a, 181b, 181c Holding wall portion
182, 182a, 182c Coupling wall portion
183, 183a, 183b, 183c Opening
184, 184a, 184b, 184c Holding space
200, 200a Cable
210 Connector
300 Power supply circuit
310 Power supply terminal
360 AV terminal

## Claims

1. An image display device comprising:
an adapter that is attached to a cable electrically connected to the image display device by holding part of the cable in a longitudinal direction of the cable; and
a housing section that defines a housing space capable of housing at least part of the adapter holding the cable and at least part of the part of the cable that is held by the adapter, and engages with the adapter.

2. The image display device according to claim 1,
wherein the adapter includes a pair of holding wall portions disposed facing each other in a first direction,
the pair of holding wall portions define a holding space for holding the cable, the holding space having an end that is closed in a second direction perpendicular to the first direction and an other end that is open in the second direction, and
a minimum distance between leading ends of the pair of holding wall portions on an open side of the holding space is smaller than a maximum distance between the pair of holding wall portions in the first direction.

3. The image display device according to claim 2,
wherein the leading end of at least one of the pair of holding wall portions is in a shape that is bent toward an other of the pair of holding wall portions.

4. The image display device according to claim 2 or 3,
wherein the housing section is shaped to house at least part of the adapter with an orientation in which the leading ends of the pair of holding wall portions in the adapter face a bottom face portion that is a bottom face of the housing space.

5. The image display device according to claim 2 or 3,
wherein the housing section is shaped to house at least part of the adapter with an orientation in which the leading ends of the pair of holding wall portions in the adapter face a lateral face portion that is a lateral face adjacent to a bottom face of the housing space.

6. The image display device according to any one of claims 1 to 5,
wherein one of the adapter or the housing section has an engagement protrusion, and an other of the adapter or the housing section has an engagement depression, and
the adapter becomes engaged with the housing section as a result of the engagement protrusion being inserted into the engagement depression.

7. The image display device according to claim 6,
wherein the housing section is a groove portion that is provided in a part of the image display device and elongated in a predetermined direction, and
one of the engagement protrusion or the engagement depression is provided along a longitudinal direction of the groove portion from an end of the groove portion in the longitudinal direction.
